# EUROPEAN PATENT APPLICATION

(11) **EP 4 446 837 A1**
(43) Date of publication of application: **16.10.2024**
(21) Application number: 24165555.4
(22) Date of filing: 22.03.2024
(51) Int. Cl.: G05B 19/418

(54) **SYSTEMS, APPARATUSES, METHODS, AND COMPUTER PROGRAM PRODUCTS FOR ARTIFICIAL INTELLIGENCE AND MACHINE LEARNING INTEGRATION WITHIN A PROCESS SIMULATION SYSTEM**

(30) Priority: 13.04.2023 US 202318300122
(71) Applicant: Honeywell International Inc., Charlotte, NC 28202 (US)
(72) Inventor: GOODMAN, John, Charlotte, 28202 (US); PALAVESH, Kalyanasundaram, Charlotte, 28202 (US); HEJAZIBAKHSH, Mahboubeh, Charlotte, 28202 (US); KARPURMATH, Vijayamahantesh, Charlotte, 28202 (US); PEDNEKAR, Abhishek Monohar, Charlotte, 28202 (US)
(74) Representative: Haseltine Lake Kempner LLP

(57) **Abstract**

Embodiments of the disclosure provide for intelligent model integration within a process simulation system. Some embodiments receive data associated with the operation of a plant, determine, using at least one specially configured algorithm and based on the received data, at least one qualifying dataset determined qualified to train an intelligent model, train the intelligent model using the at least one qualifying dataset, and deploy the trained intelligent model for use.

## Description

### TECHNOLOGICAL FIELD

Embodiments of the present disclosure generally relate to process simulation incorporating artificial intelligence and/or machine learning, and specifically to integrating intelligent model(s) within a process simulation system.

### BACKGROUND

Various embodiments of the present disclosure address technical challenges related to incorporating intelligent model(s), such as artificial intelligence and machine learning models, within a process simulation environment. Through applied effort, ingenuity, and innovation, Applicant has solved problems related to incorporating intelligent model(s) within a process simulation system by developing solutions embodied in the present disclosure, which are described in detail below.

### BRIEF SUMMARY

In general, embodiments of the present disclosure herein provide for intelligent model integration within a process simulation system. Other implementations for intelligent model integration within a process simulation system will be, or will become, apparent to one with skill in the art upon examination of the following figures and detailed description. It is intended that all such additional implementations be included within this description, be within the scope of the disclosure, and be protected by the following claims.

In accordance with one aspect of the present disclosure, a computer-implemented method integrating an intelligent mode within a process simulation system is provided. The computer-implemented method is executable utilizing any of a myriad of computing device(s) and/or combinations of hardware, software, and/or firmware. In some example embodiments, an example computer-implemented method includes receiving data associated with the operation of a plant, determining, using at least one specially configured algorithm and based on the received data, at least one qualifying dataset determined qualified to train an intelligent model, training the intelligent model using the at least one qualifying dataset, and deploying the trained intelligent model for use.

In some example embodiments, the example computer-implemented method further includes storing the received data in a repository associated with the process simulation system.

In some example embodiments the received data comprise live data received in near real-time. In some example embodiments, the at least one qualifying dataset includes flagging, based on one or more criteria and using the at least one specially configured algorithm, portions of the live data that satisfies the one or more criteria, and adopting at least one of the flagged portions of the live data as the at least one qualifying dataset.

In some example embodiments, determining the at least one qualifying dataset includes flagging, based on one or more criteria and using the at least one specially configured algorithm, a plurality of candidate datasets from historical data, and processing, using statistical model, the plurality of candidate datasets to select the at least one qualifying dataset from the plurality of candidate datasets.

In some example embodiments, the example computer-implemented method further includes extracting the at least one qualifying dataset for external processing associated with modeling via the process simulation system.

In some example embodiments, the at least one qualifying dataset comprises steady state data determined to correspond to a steady state model.

In some example embodiments, the at least one qualifying dataset comprises dynamic data determined to correspond to a dynamic model.

In some example embodiments, the intelligent model is configured to perform one or more pre-processing operations to generate one or more parameters for a process simulation model embodied by the process simulation system.

In some example embodiments, the intelligent model is configured to perform one or more post processing operations to generate one or more predictions based on data received from the plant and/or data outputted from a process simulation model.

In accordance with another aspect of the present disclosure, an apparatus integrating an intelligent mode within a process simulation system is provided. The apparatus in some embodiments includes at least one processor and at least one non-transitory memory, the at least one non-transitory memory having computer-coded instructions stored thereon. The computer-coded instructions in execution with the at least one processor causes the apparatus to perform any of the example computer-implemented methods described herein. In some other embodiments, the apparatus includes means for performing each step of any of the computer-implemented methods described herein.

In accordance with another aspect of the present disclosure, a computer program product integrating an intelligent mode within a process simulation system is provided. The computer program product in some embodiments includes at least one non-transitory computer-readable storage medium having computer program code stored thereon. The computer program code in execution with at least one processor is configured for performing any one or the example computer-implemented methods described herein.

### BRIEF DESCRIPTION OF THE SEVERAL VIEWS OF THE DRAWINGS

Having thus described the embodiments of the disclosure in general terms, reference now will be made to the accompanying drawings, which are not necessarily drawn to scale, and wherein:
FIG. 1 illustrates a block diagram of a system that may be specially configured within which embodiments of the present disclosure may operate;
FIG. 2 illustrates a block diagram of an example apparatus that may be specially configured in accordance with an example embodiment of the present disclosure;
FIG. 3 illustrates a flow chart for integrating intelligent model(s) within a process simulation system, in accordance an example embodiment of the present disclosure;
FIG. 4 illustrates a flow chart for determining training dataset based on live data in accordance an example embodiment of the present disclosure;
FIG. 5 illustrates a flow chart for determining training dataset based on historical data in accordance an example embodiment of the present disclosure.
FIG. 6 illustrates a signal diagram of an intelligent process modeling and simulation system in accordance with an example embodiment of the present disclosure.

### DETAILED DESCRIPTION

Embodiments of the present disclosure now will be described more fully hereinafter with reference to the accompanying drawings, in which some, but not all, embodiments of the disclosure are shown. Indeed, embodiments of the present disclosure may be embodied in many different forms and should not be construed as limited to the embodiments set forth herein, rather, these embodiments are provided so that this disclosure will satisfy applicable legal requirements. The term "or" is used herein in both the alternative and conjunctive sense, unless otherwise indicated. The terms "illustrative" and "example" are used to be examples with no indication of quality level. Terms such as "computing," "determining," "generating," and/or similar words are used herein interchangeably to refer to the creation, modification, or identification of data. Further, "based on," "based on in part on," "based at least on," "based upon," and/or similar words are used herein interchangeably in an open-ended manner such that they do not indicate being based only on or based solely on the referenced element or elements unless so indicated. Like numbers refer to like elements throughout.

### Overview and Technical Improvements

Various embodiments of the present disclosure address technical challenges related to integrating artificial intelligence (AI) and/or machine learning (ML) operations with the execution of process simulation models configured for modelling and/or simulating processes associated with, for example, an industrial plant (e.g., gas processing plants, oil refineries, and/or the like). Such modelling and simulating may be used monitor, control, and/or optimize equipment and processes of an industrial plant. In many applications and environments, such as industrial plants, intelligent models may be applied to process simulation models for various reasons, including improving the process simulation models. However, example solutions execute intelligent model operations in isolation with respect to process simulation models. The inventors have identified deficiencies in example solutions incorporating intelligent models in isolation with respect to process simulation models. As a non-limiting example, the inventors have determined that the capability and functionality of process simulation models may be limited by isolating the execution of intelligent models in process simulation models incorporating such intelligent models. Accordingly, there is a need for systems, apparatuses, methods, and computer program products for integrating intelligent models within a process simulation system (e.g., integrating the execution of intelligent algorithms with the execution of process simulation models) to improve the capability and functionalities of process simulation models.

Various embodiments of the present disclosure tightly integrate intelligent operations with the execution of associated process simulation model. Various embodiments of the present disclosure utilize specially configured algorithm(s) to identify and flag portions of plant data coming into the process simulation system and determined to be qualified to generate, train, test, and/or re-train a particular model, for example an artificial intelligence and/or machine learning model, and utilize the flagged data portions to generate, train, test, and/or re-train intelligent models. Moreover, various embodiments, provide for a single source of data (e.g., integrated data) for process and model predictions all within the same process simulation environment (e.g., process simulation system) embodying the process simulation model/digital twin model being executed. For example, in various embodiments, the inputs to the process simulation model(s), the outputs from the process simulation model(s), the inputs to the intelligent model(s) and the outputs to the intelligent model(s) are all stored in the same repository/database.

Accordingly, by integrating, within a process simulation system, the execution of intelligent operations (e.g., calculations thereof) with the execution of the process simulation model(s), various embodiments of the present disclosure provide numerous capability and functionality that otherwise would not be available. As one example, by integrating execution of intelligent operations, various embodiments of the present disclosure provide the capability to generate intelligent model(s), execute the intelligent model(s) against historical data, evaluate the performance of the intelligent model(s), and/or re-train the intelligent models all within the same process simulation system. Further, by utilizing a single source of data (e.g., common repository/database), which includes, inputs to the process simulation model(s), outputs from the process simulation model(s), inputs to the intelligent model(s), and/or output from the intelligent model(s), various embodiments of the present disclosure provide various functionalities associated with a process simulation system without the need to offboard to other external processes or applications. Moreover, by utilizing a common repository/database, various embodiments provide the capability to generate multiple configurations/formulations of intelligent model(s) and/or process simulation model(s), and allows for selection of the most suitable of the multiple configurations/formulations. Accordingly, various embodiments improve storage efficiency, computational efficiency, and accuracy of process simulations systems. Furthermore, various embodiments of the present disclosure allow for remote access (e.g., multiple users) to data and/or components associated with a process simulation system. Thus, eliminating the need to transmit such data and/or components between client devices. Accordingly, various embodiments of the present disclosure improves network efficiency of computing systems.

### Definitions

Many modifications and other embodiments of the disclosure set forth herein will come to mind to one skilled in the art to which this disclosure pertains having the benefit of the teachings presented in the foregoing description and the associated drawings. Therefore, it is to be understood that the embodiments are not to be limited to the specific embodiments disclosed and that modifications and other embodiments are intended to be included within the scope of the appended claims. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," "in some embodiments," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

The term "industrial plant," "plant," and/or similar terms used herein interchangeably may refer to one or more buildings, complex, or arrangement of components that perform a chemical, physical, electrical, mechanical process, and/or the like for converting input materials into one or more output products. Non-limiting examples of an industrial plant include a chemical industrial plant, automotive manufacturing plant, distillery, oil refinery, fabric manufacturing plant, and/or the like.

The term "physical component" with respect to an industrial plant may refer to asset(s) within or associated with the industrial plant. Such assets, for example, may include real-world equipment, system, or other physical structure within and/or associated with the industrial plant, and that is utilized by the industrial plant. For example, a physical component with respect to an industrial plant may comprise equipment, system, or other structure that is utilized in a process performed by the industrial plant. In an example context of an oil refinery plant, non-limiting examples of a physical component may include a furnace, a pump, a heat exchanger, and/or the like.

The term "process simulation model" refers to a model-based representation of one or more processes of an industrial plant. A process simulation model may be configured to facilitate designing, developing, analyzing, monitoring, controlling, optimizing, and/or the like one or more processes of the industrial plant. Such processes for example, may include chemical processes, biological processes, and/or the like. In one or more embodiments, a process simulation model embodies a flowsheet that describes the process flow through an industrial plant. A non-limiting example of a process simulation model is a first principle-based simulation model that models equipment and/or processes based on fundamental laws of physics, thermodynamics, kinetics, chemistry, etc. For example, a feed stream associated with a gas refrigeration plant may be defined in a process simulation model in terms of its physical and/or chemical properties. As another example, a feed stream associated with a crude oil processing plant may be defined in a process simulation model in terms of its physical and/or chemical properties. One or more inputs to a process simulation model may be fixed input(s), while one or more inputs to the process simulation model may be variable input(s). Additionally or alternatively, one or more inputs to the process simulation model may be a computed value, for example, by the process simulation model or an intelligent model. Additionally or alternatively, one or more inputs to the process simulation model may comprise data received from the plant. As a non-limiting example, such data received from the plant may comprise equipment and/or process variable measurements (e.g., sensor-based measurements). In one or more embodiments, execution of a process simulation model includes performing one or more operations. As a non-limiting example, the one or more operations may include an optimization operation with respect to one or more objective functions (e.g., minimum energy, maximum production, maximum profit, minimum cost, and/or the like) in order to determine optimal operating points/conditions for specified parameter(s). An optimal operating point/condition for a specified parameter, for example, may describe a stable operating point/condition for the specified parameter. In some embodiments, a process simulation model may comprise a steady-state model or a dynamic model. For example, in some embodiments a process simulation model may simulate a steady state process and/or a dynamic processes. In some embodiments, a process simulation model may be associated with or otherwise embodied by a digital twin model.

A "digital twin model" refers to a digital, model-based representation of physical components (e.g., equipment, system, processes, etc.) in operation. In one or more embodiments, a digital twin model is configured to run with plant data in that incoming data (e.g., operational data) from the plant is fed into the digital twin model to update the model. As such, a digital twin model may describe a representation of equipment and/or processes of an industrial plant that reflects the current operating conditions. A digital twin model may be used to monitor, refine, control, predict, and/or optimize operations of the industrial plant. In some embodiments, the digital twin model may comprise one or more process simulation models and/or one or more data-driven models. The data-driven models may comprise intelligent models.

The term "qualifying dataset" refers to data that is determined to be usable for one or more of generate, train, test, and/or update an intelligent model. In one or more embodiments, a qualifying dataset comprises a portion of the operational data received from the industrial plant system, and that is determined to satisfy one or more specified criteria for determining whether that portion of data can be used to generate, train, and/or test an intelligent model that is integrated with a process simulation model. Additionally or alternatively, in some embodiments, a qualifying dataset comprises a portion of data outputted from a process simulation model (e.g., model-predicted data), and that is determined to satisfy one or more specified criteria for determining whether that portion of data can be used to generate, train, and/or test an intelligent model that is integrated with a process simulation mode. In one or more embodiments, a qualifying dataset may comprise a portion of operational data and a portion of model-predicted data, wherein each of the portion of operational data and the portion of model-predicted data is determined, based on one or more specified criteria, as qualified to generate, train, and/or test an intelligent model. In one or more embodiments, the operational data and the model-predicted data in a qualifying dataset may be associated, where the model-predicted data may correspond to the operational data.

The term "flagged portion" refers to a portion of data that is identified and labeled as satisfying one or more criteria. In one or more embodiments, a flagged portion may correspond to a portion of operational data identified and labeled as a qualifying dataset. In one or more embodiments, a flagged portion may correspond to a portion of model-predicted data identified and labeled as a qualifying dataset. In some embodiments, flagging a portion of data includes identifying and/or recording a time stamp associated with the portion of the data.

The term "intelligent model" refers to any artificial intelligence model or machine learning model configured for a particular processing task. In some embodiments, an intelligent model may be configured to perform one or more pre-processing calculations, one or more post-processing calculations, and/or one or more process simulation model performance evaluations and corrections. In some embodiments, output of the one or more pre-processing calculations, output of the one or more post-processing operations, and/or output of the one or more process model performance evaluations and corrections is stored in a repository associated with a process simulation environment.

In some embodiments, the output of the pre-processing operation may be provided as input to a process simulation model embodied by the apparatus 200. In some embodiments, the trained intelligent model may be configured to perform post-processing operation(s) based on live data and/or model-predicted data (e.g., predicted plant measurements) outputted by the process simulation model. In some embodiments, to perform a processing operation, the apparatus 200 retrieves plant data and/or model-predicted data stored in the repository. The apparatus then provides these data to the intelligent model as part of the input to the intelligent model. In some embodiments, the output of the intelligent model may itself comprise a model-predicted data (e.g., predicted plant measurement).

### Example Systems and Apparatuses

Embodiments of the present disclosure herein include systems, apparatuses, methods, and computer program products that integrate execution of intelligent operations with process simulation model(s). It should be readily appreciated that the embodiments of the apparatus, systems, methods, and computer program product described herein may be configured in various additional and alternative manners in addition to those expressly described herein.

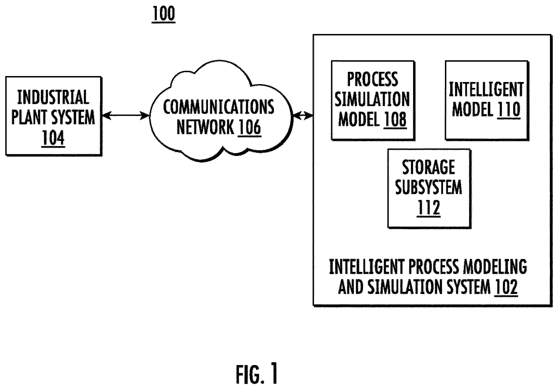

FIG. 1 illustrates a block diagram of an environment/system 100 in which embodiments of the present disclosure may operate. Specifically, FIG. 1 illustrates an industrial plant system 104 system in communication with an intelligent process modeling and simulation system 102. In some embodiments, the industrial plant System 104 communicates with the intelligent process modeling and simulation system 102 over one or more communication network(s), for example a communications network 106. In some embodiments, the industrial plant system 104 is in communication with a plurality of plant systems, each identically or similarly configured to the industrial plant system 104. In some such embodiments, the intelligent process modeling and simulation system 102 may process data associated with each industrial plant system 104 independently, and/or in some contexts processes data associated with multiple industrial plant system 104 in the aggregate (e.g., when processing all industrial plant system 104 associated with a particular entity, region, and/or the like). In some embodiments, the intelligent process modeling and simulation system 102 includes one or more process simulation models 108. The one or more process simulation models may at least in part represent a digital twin model. For example, in some embodiments, the intelligent process modeling and simulation system 102 may comprise a digital twin model that is the process simulation model 108 or may comprise a digital twin model that includes one or more process simulation models 108 and/or one or more data-driven models, where the one or more data-driven models may comprise intelligent models. As depicted in FIG. 1, in some embodiments, the intelligent process modeling and simulation system 102 includes one or more process simulation models 108 and one or more intelligent models 110. As further depicted in FIG. 1, in some embodiments, the intelligent process modeling and simulation system 102 includes storage subsystem 112 internal to the intelligent process modeling and simulation system 102. In some embodiments, the storage subsystem 112 may be external to the intelligent process modeling and simulation system 102. For example, the storage subsystem 112 may be comprise a part of a separate system in communication with the intelligent process modeling and simulation system 102 (e.g., via the communications network 106).

It should be appreciated that the communications network 106 in some embodiments is embodied in any of a myriad of network configurations. In some embodiments, the communications network 106 embodies a public network (e.g., the Internet). In some embodiments, the communications network 106 embodies a private network (e.g., an internal localized, or closed-off network between particular devices). In some other embodiments, the communications network 106 embodies a hybrid network (e.g., a network enabling internal communications between particular connected devices and external communications with other devices). The communications network 106 in some embodiments includes one or more base station(s), relay(s), router(s), switch(es), cell tower(s), communications cable(s) and/or associated routing station(s), and/or the like. In some embodiments, the communications network 106 includes one or more user controlled computing device(s) (e.g., a user owned router and/or modem) and/or one or more external utility devices (e.g., Internet service provider communication tower(s) and/or other device(s)).

Each of the components of the system 100 communicatively coupled to transmit data to and/or receive data from one another over the same or different wireless and/or wired networks embodying the communications network 106. Such configuration(s) include, without limitation, a wired or wireless Personal Area Network (PAN), Local Area Network (LAN), Metropolitan Area Network (MAN), Wide Area Network (WAN), and/or the like. Additionally, while FIG. 1 illustrate certain system entities as separate, standalone entities communicating over the communications network 106, the various embodiments are not limited to this architecture. In other embodiments, one or more computing entities share one or more components, hardware, and/or the like, or otherwise are embodied by a single computing device such that connection(s) between the computing entities are over the communications network 106 are altered and/or rendered unnecessary. For example, in some embodiments, the industrial plant system 104 includes some or all of the intelligent process modeling and simulation system 102, such that an external communications network 106 is not required.

In some embodiments, the industrial plant system 104 and the intelligent process modeling and simulation system 102 are embodied in an on-premises system within or associated with the industrial plant. In some such embodiments, the industrial plant system 104 and the intelligent process modeling and simulation system 102 are communicatively coupled via at least one wired connection. Alternatively or additionally, in some embodiments, the industrial plant system 104 embodies or includes the intelligent process modeling and simulation system 102, for example as a software component of a single enterprise terminal.

The industrial plant system 104 includes any number of computing device(s), system(s), physical component(s), and/or the like, that facilitates producing of any number of products, for example utilizing particular configurations that cause processing of particular inputs available within the industrial plant system 104. In some embodiments, the industrial plant system 104 includes one or more physical component(s), connection(s) between physical component(s), and/or computing system(s) that control operation of each physical component therein. In some embodiments, a physical component describes asset(s) within or associated with an industrial plant. Such assets, for example, may include real-world equipment, system, or other physical structure within and/or associated with the industrial plant, and that is utilized by the industrial plant. For example, a physical component with respect to an industrial plant may comprise equipment, system, or other structure that is utilized in a process performed by the industrial plant. In an example context of an oil refinery plant, non-limiting examples of a physical component may include a furnace, a pump, a heat exchanger, and/or the like. The industrial plant system 104, for example, can embody an oil refinery, an automotive engine manufacturing plant, a distillery, and/or the like, which includes physical component(s) that perform particular process(es) to alter properties of inputs to the component(s). Additionally or alternatively, in some embodiments the industrial plant system 104 includes one or more computing system(s) that are specially configured to operate the physical component(s) in a manner that produces one or more particular product(s) simultaneously. In some embodiments, an industrial plant system 104 includes one or more computing device(s) and/or system(s) embodied in hardware, software, firmware, and/or a combination thereof, that configure and/or otherwise control operation of one or more physical component(s) in the corresponding industrial plant(s). For example, in some embodiments, such computing device(s) and/or system(s) include one or more programmable logic controller(s), MPC(s), application server(s), centralized control system(s), and/or the like, that control(s) configuration and/or operation of at least one physical component. It will be appreciated that different industrial plant system(s) may include or otherwise be associated with different physical component(s), computing system(s), and/or the like.

The intelligent process modeling and simulation system 102 includes one or more computing device(s) and/or system(s) embodied in hardware, software, firmware, and/or a combination thereof, that can model and/or simulate process(es) associated with an industrial plant. In some embodiments, the intelligent process modeling and simulation system 102 includes one or more specially configured application server(s), database server(s), end user device(s), cloud computing system(s), and/or the like. Additionally or alternatively, in some embodiments, the intelligent process modeling and simulation system 102 includes one or more user device(s) that enables access to functionality provided by the intelligent process modeling and simulation system 102, for example via a web application, native application, and/or the like. For example, in some embodiments, the intelligent process modeling and simulation system 102 provides cloud-based functionality to an end-user that facilitates cloud-based monitoring, controlling, optimization, etc., of an industrial plant system, such as industrial plant system 104

The intelligent process modeling and simulation system 102 can be used for, for example, designing, analyzing, monitoring, controlling, and/or optimizing an industrial plant. In one or more embodiments, the intelligent process modeling and simulation system 102 is configured to output data that reflects optimal operating points/conditions for one or more specified parameters associated with an equipment and/or process of an industrial plant, such as an industrial plant embodied by the industrial plant system104. For example, the intelligent process modeling and simulation system 102, can be configured to perform, based at least in part on input data associated with the industrial plant, one or more modeling operations and/or simulation operations that facilitates generation of model-predicted data, wherein the model predicted prediction(s) may be used to facilitate designing, analyzing, monitoring, controlling, and/or optimizing equipment and/or process(es) of an industrial plant. In some embodiments, the intelligent process modeling and simulation system 102 includes one or more application server(s) and/or database server(s) that provide such functionality. Additionally or alternatively, in some embodiments, the intelligent process modeling and simulation system 102 includes one or more client device(s), user device(s), and/or the like, that enable access to the functionality provided via the intelligent process modeling and simulation system 102, for example via a web application, a native application, and/or the like executed on the client device. In some embodiments, the intelligent process modeling and simulation system 102 includes or embodies a display or other user interface to which a user-facing interface is renderable.

In some embodiments, the intelligent process modeling and simulation system 102 and industrial plant system 104 communicate with one another to perform the various actions described herein. For example, in some embodiments, the intelligent process modeling and simulation system 102 and the industrial plant system 104 communicate in order to generate model-predicted data associated with operation of the industrial plant (e.g., embodied by the industrial plant system 104). Additionally or alternatively, in some embodiments, the intelligent process modeling and simulation system 102 and the industrial plant system 104 communicate to facilitate control or adjustment of operation of physical component(s) in the industrial plants based at least in part on the generated model-predicted data. For example, in some embodiments the intelligent process modeling and simulation system 102 and the industrial plant system 104 can communicate to automatically configure or reconfigure one or more physical component(s) of the industrial plant based on the model-predicted data. In some embodiments, the intelligent process modeling and simulation system 102 includes a process simulation model 108 and at least one intelligent model 110 integrated with the process simulation model. In some embodiments, the intelligent process modeling and simulation system 102 includes a plurality of simulation models 108 and/or a plurality of intelligent models 110.

In some embodiments, a process simulation model 108 is a model-based representation of one or more assets of an industrial plant (e.g., industrial plant embodied by the industrial plant system 104). A process simulation model 108 may comprise one or more asset models, that each represent an asset associated with the industrial plant system 104. An asset may include equipment and/or processes associated with the industrial plant system 104 (e.g., industrial plant thereof) and/or their units. One or more inputs to process simulation model 108 may be fixed input(s), while one or more inputs to process simulation model 108 may be variable input(s). Additionally or alternatively, one or more inputs to the process simulation model may be a computed value. In one or more embodiments, an input to the process simulation model 108 that is a computed value is determined (e.g., computed) by the process simulation model 108 and/or determined (e.g., computed) by an intelligent model 110 embodied by the intelligent process modeling and simulation system 102. Additionally or alternatively, one or more inputs to the process simulation model may comprise data received from the industrial plant system 104. Such data (e.g., plant data) may comprise operational data received from the plant, such as process variable measurements and/or equipment variable measurements. In an example context, one or more equipment and/or processes associated with the plant system 104 may include sensor devices for measuring certain variables (e.g., temperature, pressure, etc.) with respect to the equipment and/or processes. In some embodiments, a particular process simulation model 108 may be a first principle-based simulation model that models equipment and/or processes based on fundamental laws of physics, thermodynamics, kinetics, chemistry, etc. For example, a feed stream associated with a gas refrigeration plant, or a crude oil processing plant may be defined in the process simulation model 108 in terms of its physical and/or chemical properties.

In one or more embodiments, process simulation model 108 can implement an algorithm based on inter-related asset models for the industrial plant (e.g., embodied by the industrial plant system 104 ) to model and/or simulate assets of the plant, and to generate prediction(s). In some embodiments, prediction(s) may comprise model-predicted data that represent or otherwise reflect predicted plant performance, comparison of current plant performance against historical plant performance to detect changes associated with operation of the plant such as changes in equipment and/or process(es). Additionally or alternatively, the model-predicted data may comprise data indicative of operating points/condition(s) for one or more equipment and/or process variables. In one or more embodiments, process simulation model 108 may facilitate designing, developing, analyzing, monitoring, controlling, optimizing, and/or the like of one or more equipment and/or processes of the industrial plant. Such processes, for example, may include chemical processes, biological processes, and/or the like. In one or more embodiments, process simulation model 108 embodies a flowsheet that describes the process flow through the industrial plant.

In one or more embodiments the intelligent process modeling and simulation system 102 and/or the process simulation model 108 may represent a digital twin (e.g., digital twin model) with respect to an industrial plant embodied by the industrial plant system 104. For example, as described above, in one or more embodiments, the process simulation model 108 is a digital twin model of one or more processes of the industrial plant. For example, in some examples, the intelligent process modeling and simulation system 102 comprises a digital twin model that is a process simulation model 108. In some examples, the intelligent process modeling and simulation system 102 comprises a digital twin model that includes one or more process simulation models and/or one or more data-driven models, where the one or more data-driven models may comprise intelligent models. A digital twin model with respect to an industrial plant may describe a model-based representation of physical components (e.g., equipment, system, processes, etc.) in operation. The digital twin model (e.g., process simulation model 108 thereof) may be configured to run with plant data in that incoming data from the plant is fed into the digital twin model to update the model. As described above, plant data (e.g., operational data) may include measurements of one or more measured process variables and/or equipment variables. As such, a digital twin model may describe at least in part a representation of equipment and/or processes of an industrial plant that reflects the current operating conditions, and may be used to monitor, refine, control, predict, and/or optimize operations of the industrial plant. Additionally or alternatively, the digital twin model may be used to collect and store various data associated with the operation of the industrial plant.

In one or more embodiments, execution of a process simulation model 108 includes performing one or more operations to output prediction(s) (e.g., model-predicted data) that reflect operation of the industrial plant embodied by the industrial plant system 104, and that in turn can be used for monitoring, controlling, analyzing, and/or optimizing equipment and processes of the industrial plant. As a non-limiting example, the one or more operations may include an optimization operation with respect to one or more optimization objective functions (e.g., minimum energy, maximum production, maximum profit, minimum cost, and/or the like) and/or constraints in order to determine optimal operating points/conditions for specified parameter(s). An optimal operating point/condition for a specified parameter, for example, may describe a stable operating point/condition for the specified parameter. Non-limiting examples of constraints with respect to an optimization operation include physical equipment limits, safe operating limits, product quality specifications, product flows (minimum or maximum limits), energy use, feed availability, and/or the like. In some embodiments, a process simulation model 108 may comprise a steady-state model or a dynamic model in that the process simulation model 108 may be a steady state representation or dynamic representation of process(es) of and industrial plant.

An intelligent model 110 embodied by the intelligent process modeling and simulation system 102 can include one or more specially configured algorithms to support one or more functionalities associated with the intelligent process modeling and simulation system. For example, in some embodiments, the intelligent models 110 can implement one or more specially configured algorithms to support one or more functionalities associated with modeling, simulating, analyzing, and/or generating model-predicted data. In some embodiments, an intelligent model 110 may be configured to implement one or more pre-processing calculation algorithms to support modeling and simulation functionalities of the process simulation model 108. Additionally or alternatively, in some embodiments, an intelligent model 110 may be configured to implement one or more post-processing algorithms to generate model-predicted data. In some embodiments, the intelligent model(s) 110 may be configured to implement one or more evaluation and correction algorithms to assess performance of the process simulation model 108 and correct for discrepancies between the model-predicted data and actual plant measurements. It would be appreciated that these are examples, and not intended to be limiting.

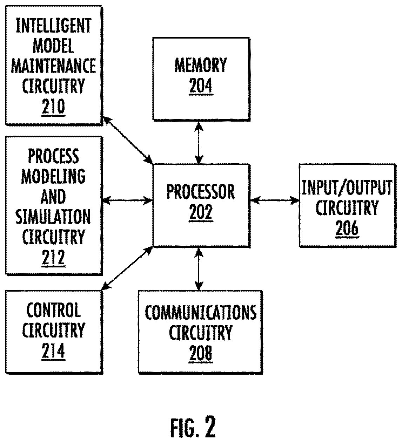

FIG. 2 illustrates a block diagram of an example apparatus that may be specially configured in accordance with an example embodiment of the present disclosure. Specifically, FIG. 2 depicts an example computing apparatus 200 ("apparatus 200") specially configured in accordance with at least some example embodiments of the present disclosure. In some embodiments, the intelligent process modeling and simulation system 102, and/or a portion thereof is embodied by one or more system(s), such as the apparatus 200 as depicted and described in FIG. 2. The apparatus 200 includes processor 202, memory 204, input/output circuitry 206, communications circuitry 208, intelligent model maintenance circuitry 210, and process modeling simulation circuitry 212. In some embodiments, the apparatus 200 is configured, using one or more of the sets of circuitry 202-214 to execute and perform the operations described herein.

In general, the terms computing entity (or "entity" in reference other than to a user), device, system, and/or similar words used herein interchangeably may refer to, for example, one or more computers, computing entities, desktop computers, mobile phones, tablets, phablets, notebooks, laptops, distributed systems, items/devices, terminals, servers or server networks, blades, gateways, switches, processing devices, processing entities, set-top boxes, relays, routers, network access points, base stations, the like, and/or any combination of devices or entities adapted to perform the functions, operations, and/or processes described herein. Such functions, operations, and/or processes may include, for example, transmitting, receiving, operating on, processing, displaying, storing, determining, creating/generating, monitoring, evaluating, comparing, and/or similar terms used herein interchangeably. In one embodiment, these functions, operations, and/or processes can be performed on data, content, information, and/or similar terms used herein interchangeably. In this regard, the apparatus 200 embodies a particular, specially configured computing entity transformed to enable the specific operations described herein and provide the specific advantages associated therewith, as described herein.

Although components are described with respect to functional limitations, it should be understood that the particular implementations necessarily include the use of particular computing hardware. It should also be understood that in some embodiments certain of the components described herein include similar or common hardware. For example, in some embodiments two sets of circuitry both leverage use of the same processor(s), network interface(s), storage medium(s), and/or the like, to perform their associated functions, such that duplicate hardware is not required for each set of circuitry. The use of the term "circuitry" as used herein with respect to components of the apparatuses described herein should therefore be understood to include particular hardware configured to perform the functions associated with the particular circuitry as described herein.

Particularly, the term "circuitry" should be understood broadly to include hardware and, in some embodiments, software for configuring the hardware. For example, in some embodiments, "circuitry" includes processing circuitry, storage media, network interfaces, input/output devices, and/or the like. Alternatively or additionally, in some embodiments, other elements of the apparatus 200 provide or supplement the functionality of another particular set of circuitry. For example, the processor 202 in some embodiments provides processing functionality to any of the sets of circuitry, the memory 204 provides storage functionality to any of the sets of circuitry, the communications circuitry 208 provides network interface functionality to any of the sets of circuitry, and/or the like.

In some embodiments, the processor 202 (and/or co-processor or any other processing circuitry assisting or otherwise associated with the processor) is/are in communication with the memory 204 via a bus for passing information among components of the apparatus 200. In some embodiments, for example, the memory 204 is non-transitory and may include, for example, one or more volatile and/or non-volatile memories. In other words, for example, the memory 204 in some embodiments includes or embodies an electronic storage device (e.g., a computer readable storage medium). In some embodiments, the memory 204 is configured to store information, data, content, applications, instructions, or the like, for enabling the apparatus 200 to carry out various functions in accordance with example embodiments of the present disclosure.

The processor 202 may be embodied in a number of different ways. For example, in some example embodiments, the processor 202 includes one or more processing devices configured to perform independently. Additionally or alternatively, in some embodiments, the processor 202 includes one or more processor(s) configured in tandem via a bus to enable independent execution of instructions, pipelining, and/or multithreading. The use of the terms "processor" and "processing circuitry" should be understood to include a single core processor, a multi-core processor, multiple processors internal to the apparatus 200, and/or one or more remote or "cloud" processor(s) external to the apparatus 200.

In an example embodiment, the processor 202 is configured to execute instructions stored in the memory 204 or otherwise accessible to the processor. Alternatively or additionally, the processor 202 in some embodiments is configured to execute hard-coded functionality. As such, whether configured by hardware or software methods, or by a combination thereof, the processor 202 represents an entity (e.g., physically embodied in circuitry) capable of performing operations according to an embodiment of the present disclosure while configured accordingly. Alternatively or additionally, as another example in some example embodiments, when the processor 202 is embodied as an executor of software instructions, the instructions specifically configure the processor 202 to perform the algorithms embodied in the specific operations described herein when such instructions are executed.

As one particular example embodiment, the processor 202 is configured to perform various operations associated with the process simulation model 108 and/or the intelligent model(s) 110. In some embodiments, the processor 202 includes hardware, software, firmware, and/or a combination thereof, for implementing one or more algorithms to model and simulate the execution of defined process(es) within the process simulation model 108, for example, based on inter-related asset models associated with the industrial plant system 104. For example, in some embodiments, the processor 202 includes hardware, software, firmware, and/or a combination thereof, for performing a variety of calculations associated with the process simulation model 108 and/or the intelligent model(s) 110. In some embodiments, the processor 202 can facilitate storing, sending and/or receiving data associated with the execution of the process simulation model 108 and/or the intelligent model(s) 110 among various components of the system 100. For example, in some embodiments, to facilitate integration of the process simulation model 108 and the intelligent model(s) 110s, various data associated with performing various functionalities of the process simulation model 108 and the intelligent model(s) 110 are stored in the storage subsystem 112 and accessible to the process simulation model 108 and the intelligent model(s) 110. As such, in some embodiments, each of the process simulation model 108 and the intelligent models 110 can store, send, and/or receive data associated with executing the process simulation model 108 and the intelligent models 110 utilizing a single repository (e.g., storage subsystem 112). In some embodiments, such data may include current live data generated by the industrial plant system 104, current simulated data (e.g., current model-predicted data generated by a process simulation model 108 or intelligent model 110), historical live data, historical simulated data (e.g., historical model-predicted data generated by a process simulation model 108 or intelligent model 110). It would be appreciated that these are examples, and not intended to be limiting.

In some embodiments, the apparatus 200 includes input/output circuitry 206 that provides output to the user and, in some embodiments, to receive an indication of a user input. In some embodiments, the input/output circuitry 206 is in communication with the processor 202 to provide such functionality. The input/output circuitry 206 may comprise one or more user interface(s) and in some embodiments includes a display that comprises the interface(s) rendered as a web user interface, an application user interface, a user device, a backend system, or the like. In some embodiments, the input/output circuitry 206 also includes a keyboard, a mouse, a joystick, a touch screen, touch areas, soft keys a microphone, a speaker, or other input/output mechanisms. The processor 202 and/or input/output circuitry 206 comprising the processor may be configured to control one or more functions of one or more user interface elements through computer program instructions (e.g., software and/or firmware) stored on a memory accessible to the processor (e.g., memory 204, and/or the like). In some embodiments, the input/output circuitry 206 includes or utilizes a user-facing application to provide input/output functionality to a client device and/or other display associated with a user.

In some embodiments, the apparatus 200 includes communications circuitry 208. The communications circuitry 208 includes any means such as a device or circuitry embodied in either hardware or a combination of hardware and software that is configured to receive and/or transmit data from/to a network and/or any other device, circuitry, or module in communication with the apparatus 200. In this regard, in some embodiments the communications circuitry 208 includes, for example, a network interface for enabling communications with a wired or wireless communications network. Additionally or alternatively in some embodiments, the communications circuitry 208 includes one or more network interface card(s), antenna(s), bus(es), switch(es), router(s), modem(s), and supporting hardware, firmware, and/or software, or any other device suitable for enabling communications via one or more communications network(s). Additionally or alternatively, the communications circuitry 208 includes circuitry for interacting with the antenna(s) and/or other hardware or software to cause transmission of signals via the antenna(s) or to handle receipt of signals received via the antenna(s). In some embodiments, the communications circuitry 208 enables transmission to and/or receipt of data from user device, one or more asset(s) or accompanying sensor(s), and/or other external computing device in communication with the apparatus 200.

The processing process modeling simulation circuitry 212 includes hardware, software, firmware, and/or a combination thereof, configured to perform various functionalities associated with the process simulation model 108. In some embodiments, the process modeling simulation circuitry 212 includes hardware, software, firmware, and/or a combination thereof configured to perform a variety of calculations to simulate the execution of defined process(es) associated with the industrial plant system 104. In some embodiments, the process modeling simulation circuitry 212 is configured to simulate process(es)/equipment conditions based on first-principles modelling.

In some embodiments, the process modeling simulation circuitry 212 may be configured to perform steady-state simulations. In some embodiments, the process modeling simulation circuitry 212 may be configured to perform dynamic simulations. In some embodiments, the process modeling simulation circuitry 212 includes hardware, software, firmware, and/or a combination thereof, configured to create and maintain flowsheets (e.g., process definition document(s)) which simulate a general flow of plant processes/equipment of the plant embodied by the industrial plant system 104. The flowsheets can define asset models and their associated properties utilized by the process simulation model 108 to perform a simulation of the process. In some embodiments, the flowsheet is configured to model relationships between processes/equipment of the plant. The flowsheet model, for example, may relate individual processing equipment (e.g., pumps, heat exchangers, distillation unit, etc.) to the performance parameters of overall plant process. In some embodiments, the process simulation model 108 is configured perform one or more of its calculations (e.g., implement one or more algorithms) within the flowsheet. Additionally, in some embodiments, an intelligent model 110 embodied by the intelligent process modeling and simulation system 102 is configured to perform one or more of its calculations (e.g., implement one or more algorithms) within the flowsheet. In some embodiments, the process modeling simulation circuitry 212 includes a separate processor, specially configured field programmable gate array (FPGA), or a specially programmed application specific integrated circuit (ASIC).

The process modeling simulation circuitry 212 includes hardware, software, firmware, and/or a combination thereof, configured to receive input data from the storage subsystem 112, perform, based on the input data, a variety of calculations to simulate the execution of a defined process(es) associated with the industrial plant system 104, and generate predictions (e.g., model-predicted data) that may be used to, for example, monitor, control, and/or optimize the industrial plant system 104 (e.g., plant thereof). In some of the embodiments, substantially all of the data utilized by the process simulation model 108 to perform its various functionalities is stored in the storage subsystems 112.

The intelligent model maintenance circuitry 210 includes hardware, software, firmware, and/or a combination thereof, that performs various functionalities associated with the intelligent model(s) 110. For example, intelligent model maintenance circuitry 210 may implement algorithms to generate models for continuous monitoring. In some embodiments, the intelligent model maintenance circuitry 210 includes hardware, software, firmware, and/or a combination thereof, that supports configuration and/or generation of intelligent model(s) 110 configured to be applied to the process simulation model 108, generate model-predicted data, and/or evaluate performance of the process simulation model 108. For example, in some embodiments, intelligent model maintenance circuitry 210 includes hardware, software, firmware, and/or a combination thereof, for generating, training, testing, and/or fine-tuning the intelligent model(s) 110. In some embodiments, the intelligent model maintenance circuitry 210 includes hardware, software, firmware, and/or a combination thereof, that stores the one or more intelligent models 110, stores output of the one or more intelligent models 110, and/or model configuration data associated with the one or more intelligent models 110 in the storage subsystem 112.

In some embodiments, the intelligent model maintenance circuitry 210 includes hardware, software, firmware, and/or a combination thereof, that receives, from one or more repositories (e.g., storage subsystem 112) associated with the intelligent process modeling and simulation system 102, input data for the one or more intelligent models 110. In some embodiments, input data to the one or more intelligent models 110 comprise plant data (e.g., operational data for the plant) associated with one or more processes/equipment of the plant. The plant data (e.g., operational data), for example, may include measurements of various process variables and/or various equipment variables associated with the process(es) and/or equipment of the plant. For example, one or more processes and/or equipment of the plant may include sensors configured for measuring the various process variables and/or equipment variables. Additionally or alternatively, in some embodiments, input data to the intelligent model(s) 110 comprise simulated data (e.g., model-predicted data) output from the process simulation model 108. It would be appreciated that the input data to the intelligent model(s) 110 may comprise other data, and may not be limited to plant data (e.g., operational data) or simulated data (e.g., model-predicted data).

In some embodiments, the intelligent model maintenance circuitry 210 includes hardware, software, firmware, and/or a combination thereof, that causes intelligent models 110 embodied by the intelligent process modeling and simulation system 102 to perform pre-processing calculation(s) (e.g., implement pre-processing algorithms), wherein output of the pre-processing calculation(s) is provided as input to the process simulation model 108. For example, the intelligent models 110 may be configured to process plant data, received in real-time/near real-time (e.g., live data), to generate model parameters that, for example, reflect the current state of the assets in the industrial plant (e.g., heat exchanger fouling, reactor kinetic parameters, coke thickness, and/or the like) in order to improve the overall accuracy of the process simulation model(s) and/or intelligent process modeling and simulation system 102. In some embodiments, the model parameters, may represent predicted measurements for one or more process variables not measured by the industrial plant system 104 (e.g., not measured by the industrial plant system 104 or only partially measured by the industrial plant system 104). In some embodiments, the predicted measurements are provided to the process simulation model 108 to, for example, to facilitate modeling and simulation of the plant process(es)/equipment using the process simulation model 108.

Additionally or alternatively, in some embodiments, the intelligent model maintenance circuitry 210 includes hardware, software, firmware, and/or a combination thereof, that causes intelligent models 110 embodied by the intelligent process modeling and simulation system 102 to perform one or more post-processing calculations to output model-predicted data. In some embodiments, the one or more intelligent models may perform the post-processing calculations based on plant data from the industrial plant system 104 and/or model-predicted data output of the process simulation model 108. In some embodiments, model-predicted data output from the one or more intelligent models and/or model-predicted output from the process simulation model 108 may be used to facilitate monitoring, controlling, and/or optimizing of the industrial plant system 104 (e.g., industrial plant thereof). As such, in some embodiments, one or more intelligent models 110 may be configured to supplement the process simulation model 108.

Additionally or alternatively, in some embodiments, the intelligent model maintenance circuitry 210 includes hardware, software, firmware, and/or a combination thereof, that causes intelligent models 110 embodied by the intelligent process modeling and simulation system 102 to perform one or more evaluation calculations to assess the performance of the process simulation model 108 (e.g., as the process simulation model executes). As such, a prediction of plant measurements may be obtained at an initial point, and as the process model defined is perturbed (e.g., performing optimization studies), the bias/correction is automatically being generated as a function of the new conditions to match the plant more closely. As such, in some embodiments, one or more intelligent-based calculations performed by at least one intelligent models 110 is configured for being applied to the process simulation model 108, to supplement the process simulation model 108, and/or to evaluate and correct the process simulation model 108. It would be appreciated that these are examples, and not intended to be limiting.

In some embodiments, to integrate, within the intelligent process modeling and simulation system 102, the intelligent models 110 (e.g., the one or more intelligent-based calculations thereof) with the process simulation model 108, plant data (e.g., operational data) from the industrial plant system 104, model-predicted data generated by the process simulation model 108, predicted measurements generated by an intelligent model 110, input to the process simulation model 108, model-predicted data generated by the intelligent models 110, and/or other data for facilitating the various functionality of the process simulation model 108 and the intelligent model(s) 110 are stored in the storage subsystem 112. As such, storage subsystem 112) may comprise at least a continuum of plant data (e.g., operational data) and/or model-predicted data.

In some embodiments, the intelligent model maintenance circuitry 210 may comprise or otherwise embody one or more specially configured algorithms to facilitate, within the intelligent process modeling and simulation system 102, integration of the intelligent model(s) 110 (e.g., the one or more intelligent-based calculations thereof) with the process simulation model 108. In some embodiments, the intelligent model maintenance circuitry 210 includes hardware, software, firmware, and/or a combination thereof, that determines, using the one or more specially configured algorithms, at least one qualifying dataset for training and/or testing the intelligent models 110. In some embodiments, the at least one qualified data set is determined based on data associated with the operation of the plant (e.g., plant data and/or model-predicted data) and received from storage subsystem 112). It would be appreciated that in some embodiments, that intelligent model maintenance circuitry 210 may receive plant data directly from the industrial plant system 104.

In some embodiments, the intelligent model maintenance circuitry 210 is associated with a training phase and a prediction phase. In some embodiments, the intelligent model maintenance circuitry 210 is configured to cause the intelligent model(s) 110 embodied by the intelligent process modeling and simulation system 102 to undergo a training process, using the at least one qualifying dataset, in order to identify features and to determine optimal coefficients representing adjustment or weights to apply with respect to the features in order to generate accurate predictions (e.g., input to the process simulation model 108, model-predictions, process model evaluation, and/or the like). As such, in some examples, the weights for the intelligent model(s) 110 may be generated during a training phase of the intelligent model(s) 110.

In some embodiments, to determine the at least one qualified data set, the intelligent model maintenance circuitry 210 includes hardware, software, firmware, and/or a combination thereof, configured to automatically flag, using the one or more specially configured algorithms and based on plant data and/or model-predicted data, qualifying dataset(s) for generating and/or training an intelligent models 110 configured to perform various functionalities associated with generating model-predicted data in a simulation environment (e.g., intelligent process modeling and simulation system 102). In some embodiments, the intelligent model maintenance circuitry 210 is configured to receive (e.g., in real-time or near real-time) current data comprising current plant data and/or model-predicted data; flag from the received current data, based on one or more criteria and using the one or more specially configured algorithms, at least one qualifying dataset determined qualified to train and/or test an intelligent model 110.

Additionally or alternatively, in some embodiments, the intelligent model maintenance circuitry 210 is configured to receive historical data comprising historical plant data and/or historical model-predicted data; flag from the received historical data based on one or more criteria and using the one or more specially configured algorithms, at least one qualifying dataset determined qualified to train and/or test an intelligent model 110. In some embodiments, the at least one qualifying datasets may comprise steady state data determined to correspond to a steady state model determined to correspond to a steady state model. For example, in some embodiments, the one or more criteria may include a steady state model requirement, wherein the one or more specially configured algorithm may be configured to detect a steady state with respect to the process simulation model 108, and flag the corresponding data as a candidate dataset for training and/or testing an intelligent model 110. In some embodiments, the at least one qualifying datasets may comprise dynamic data determined to correspond to a dynamic model. For example, in some embodiments, the one or more criteria may include a steady state model requirement, wherein the one or more specially configured algorithm may be configured to detect a steady state with respect to the process simulation model 108, and flag the corresponding data as a candidate dataset for training and/or testing an intelligent model 110. It should be understood that these are examples, and not intended to be limited.

In some embodiments, the intelligent model maintenance circuitry 210 includes hardware, software, firmware, and/or a combination thereof, configured to process the flagged candidate datasets using a statistical analysis technique to determine the at least one qualifying dataset. In some embodiments, the intelligent model maintenance circuitry 210 includes hardware, software, firmware, and/or a combination thereof, configured to extract the at least one qualifying dataset for external processing associated with modeling via the intelligent process modeling and simulation system 102. Such external processing may include generating, training, validating, and/or updating an intelligent model, such as intelligent model 110. In some embodiments, the intelligent model maintenance circuitry 210 includes a separate processor, specially configured field programmable gate array (FPGA), or a specially programmed application specific integrated circuit (ASIC).

The optional control circuitry 214 includes hardware, software, firmware, and/or a combination thereof, that supports various functionality associated with causing configuration or causing other operation of at least one physical component (e.g., processing equipment, devices, systems, etc.) associated with the industrial plant system 104 (e.g., plant thereof). For example, in some embodiments, the optional control circuitry 214 includes hardware, software, firmware, and/or a combination thereof, that facilitates and/or causes automatic reconfiguration of the operation of at least one physical component based at least in part on the output of the process simulation model 108 and/or the intelligent model(s) 110. In some embodiments, the optional control circuitry 214 includes a separate processor, specially configured field programmable gate array (FPGA), or a specially programmed application specific integrated circuit (ASIC).

### Example Computer Implemented Process

Having described example systems, apparatuses, data architectures, and model implementations in accordance with the present disclosure, example processes for integrating intelligent models within a process simulation system (such as intelligent process modeling and simulation system 102) will now be discussed. It will be appreciated that each of the flowcharts depicts an example computer-implemented process that is performable by one or more of the apparatuses, systems, devices, and/or computer program products described herein, for example utilizing one or more of the specially configured components thereof.

The blocks indicate operations of each process. Such operations may be performed in any of a number of ways, including, without limitation, in the order and manner as depicted and described herein. In some embodiments, one or more blocks of any of the processes described herein occur in-between one or more blocks of another process, before one or more blocks of another process, in parallel with one or more blocks of another process, and/or as a sub-process of a second process. Additionally or alternatively, any of the processes in various embodiments include some or all operational steps described and/or depicted, including one or more optional blocks in some embodiments. With regard to the flowcharts illustrated herein, one or more of the depicted block(s) in some embodiments is/are optional in some, or all, embodiments of the disclosure. Optional blocks are depicted with broken (or "dashed") lines. Similarly, it should be appreciated that one or more of the operations of each flowchart may be combinable, replaceable, and/or otherwise altered as described herein.

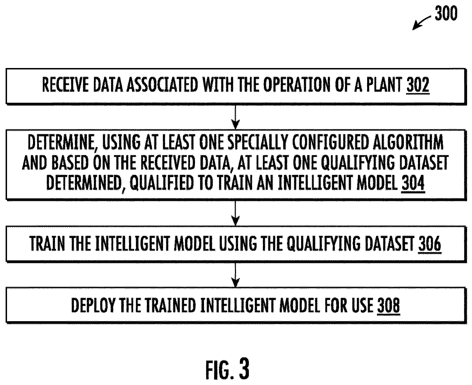

FIG. 3 illustrates a flowchart including example operations of an example process for integrating intelligent-based calculations within a process simulation system. Specifically, FIG. 3 illustrates an example computer-implemented process 300. In some embodiments, the process 300 is embodied by computer program code stored on a non-transitory computer-readable storage medium of a computer program product configured for execution to perform the process as depicted and described. Alternatively or additionally, in some embodiments, the process 300 is performed by one or more specially configured computing devices, such as the apparatus 200 alone or in communication with one or more other component(s), device(s), system(s), and/or the like. In this regard, in some such embodiments, the apparatus 200 is specially configured by computer-coded instructions (e.g., computer program instructions) stored thereon, for example in the memory 204 and/or another component depicted and/or described herein and/or otherwise accessible to the apparatus 200, for performing the operations as depicted and described. In some embodiments, the apparatus 200 is in communication with one or more external apparatus(es), system(s), device(s), and/or the like, to perform one or more of the operations as depicted and described. For example, the apparatus 200 in some embodiments is in communication with separate physical component(s) of one or more industrial plants, and/or the like. For purposes of simplifying the description, the process 300 is described as performed by and from the perspective of the apparatus 200.

At block 302, the apparatus 200 includes intelligent model maintenance circuitry 210, process modeling simulation circuitry 212, optional control circuitry 214, communications circuitry 208, input/output circuitry 206, processor 202, and/or the like, or a combination thereof, that receives data associated with the operation of a plant. The data may be received from an industrial plant system associated with the plant, such as industrial plant system 104. In some embodiments, the data received from the industrial plant system comprises operational data of a plants embodied by the industrial plant system. In some embodiments, the operational data includes at least measurement data for one or more process variables and/or equipment variables of a process and/or equipment associated with the industrial plant. For example, the industrial plant system may include one or more sensors, where the one or more sensors may be configured to measure (e.g., continuously, periodically, and/or the like) process variables and/or equipment variables. Examples of such process variables and/or equipment variables may include flow rate, temperature, pressure, and/or the like. The one or more sensors may, for example, be configured to continuously, and/or periodically, measure one or more process variables and/or equipment variables. In some embodiments, the one or more sensors may be configured to automatically measure the corresponding process variables and/or equipment variables. The industrial plant system (e.g., industrial plant system 104) may transmit the output of the one or more sensors (e.g., process variable measurements and/or equipment variable measurements) in real-time or near-real-time. Additionally or alternatively, the industrial plant system may transmit measurement data derived from output of the one or more sensors to the apparatus 200. Additionally or alternatively, in some embodiments, data received from the industrial plant system may include laboratory measurements of one or more variables (e.g., flow rate temperature, pressure, and/or the like) associated with operation of the industrial plant. In some embodiments, at least a portion of the data received from the industrial plant system comprise live data, in that the data is transmitted from the industrial plant system in real-time or near real-time and is received by the apparatus 200 in real-time or near real-time. In some embodiments, the apparatus 200 receives the data directly from a repository associated with the industrial plant system, where the repository receives the data from the data source(s) (e.g., one or more sensors) in real-time and/or near real-time, where the apparatus 200 receives the data from the repository, for example, in real-time or near-real time. As described above, in one or more embodiments, the process simulation model (e.g., digital twin) may be configured to run against plant data. Additionally or alternatively, in some embodiments, the apparatus 200 causes the received data (e.g., live data) to be stored in a repository associated with or otherwise embodied by the apparatus 200, such as storage subsystem 112. Additionally or alternatively, in one or more embodiments, the apparatus causes the output of a process simulation model embodied by the apparatus 200 to be stored in the repository (e.g., storage subsystem 112). In one or more embodiments, the operational data received from the industrial plant system and the output data from a process simulation model are stored in the same repository (e.g., storage subsystem 112) to facilitate integration of one or more intelligent models with process simulation model(s). For example, in some embodiments, a portion (e.g., some, all) of data received as input by the process simulation model (e.g., embodied by the apparatus 200) and/or a portion (e.g., some, all) of the data received as input by the intelligent model (e.g., embodied by the apparatus 200) is received from the shared repository (e.g., storage subsystem 112). Additionally or alternatively, a portion (e.g., some, all) of data used to generate, train, test, and/or update an intelligent model may be obtained from the repository (e.g., storage subsystem 112)

At block 304, the apparatus 200 includes intelligent model maintenance circuitry 210, process modeling simulation circuitry 212, optional control circuitry 214, communications circuitry 208, input/output circuitry 206, processor 202, and/or the like, or a combination thereof, that determines, using at least one specially configured algorithm and based on the received data, at least one qualifying dataset from the data received by the apparatus 200 (e.g., at block 302). In one or more embodiments, a qualifying dataset comprises a portion of the operational data received from the industrial plant system, and that is determined by the apparatus 200 (e.g., by the intelligent model maintenance circuitry 210 thereof) to satisfy one or more specified criteria for determining whether that portion of data can be used to generate, train, test, and/or update an intelligent model whose execution is integrated with a process simulation model embodied by the apparatus 200. Additionally or alternatively, in some embodiments, a qualifying dataset comprises a portion of data outputted from a process simulation model (e.g., model-predicted data), and that is determined by the apparatus 200 (e.g., by the intelligent model maintenance circuitry 210 thereof) to satisfy one or more criteria for determining whether that portion of data can be used to generate, train, test, and/or update an intelligent model whose execution is integrated with a process simulation model embodied by the apparatus 200. In one or more embodiments, a qualifying dataset may comprise a portion of operational data and a portion of model-predicted data that is determined, based on one or more specified criteria, as qualified to generate, train, test, and/or update an intelligent model. In one or more embodiments, the operational data and the model-predicted data in a qualifying dataset may be associated, where the model-predicted data may correspond to the operational data. In one or more embodiments, the operational data in a qualifying dataset may be determined based at least in part on the model-predicted data in the qualifying dataset (e.g., based at least in part on associated timestamp with respect to the operational data and the model predicted data). In one or more embodiments, the model-predicted data in a qualifying dataset may be determined based at least in part on the operational data in the qualifying dataset (e.g., based at least in part on associated timestamp with respect to the operational data and the model predicted data).

As further described herein, in one or more embodiments, an intelligent model may be configured to support various functionalities of the apparatus 200. Moreover, an intelligent model integrated with a process simulation model provides various capabilities that otherwise would not be available, including the capability to execute process simulation model(s) and to generate, train, and/or test intelligent models configured for improving the accuracy of the process simulation system(s), all within the same process simulation environment. As such, eliminating the need to offboard to other applications and/or tools, which in turn reduces network traffic. An intelligent model may be deemed to be integrated with a process simulation model where the execution of the intelligent model is tightly integrated with the execution of a process simulation model. Such integration may be defined based at least in part on the intelligent model and the process model having a shared source of data (e.g., single source of data) for executing the various functionalities of the process simulation model and the intelligent model(s). Additionally, such integration may be defined based at least in part on the interrelatedness of the inputs and outputs of the process simulation model(s) and the intelligent model(s).

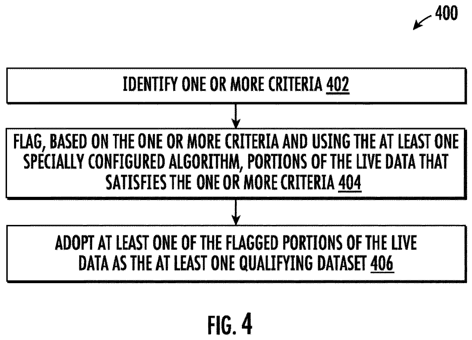

In some embodiments, a qualifying dataset may be determined in accordance with the process 400 depicted in FIG. 4, which provides an example flowchart for determining, based on live data received from the industrial plant system and/or data outputted from a process simulation model, at least one qualifying dataset for generating, training, and/or testing an intelligent model that is integrated with a process simulation model. At block 402, the apparatus 200 includes intelligent model maintenance circuitry 210, process modeling simulation circuitry 212, optional control circuitry 214, communications circuitry 208, input/output circuitry 206, processor 202, and/or the like, or a combination thereof, that identifies one or more criteria to be satisfied in order to qualify as a dataset that can be used to generate, train, test, and/or update an intelligent model. In one or more embodiments, the one or more criteria is configurable. In one or more embodiments, the one or more criteria may be identified based at least in part on the desired process simulation model and/or the desired intelligent model. As a non-limiting example, in one or more embodiments, where the process simulation model is a steady state model, the one or more criteria may include a criteria that a qualifying dataset must comprise steady state data. As another non-limiting example, the one or more criteria may include availability of a complete set of current laboratory measurements associated with operation of the plant. As yet another non-limiting example, the one or more criteria may include that certain process values (e.g., critical process values) are within specified ranges to, for example, remove abnormal process operation such as when equipment is out of service. As would be appreciated the one or more criteria may comprise a single criterion or may comprise multiple criteria.

In block 404, the apparatus 200 includes intelligent model maintenance circuitry 210, process modeling simulation circuitry 212, optional control circuitry 214, communications circuitry 208, input/output circuitry 206, processor 202, and/or the like, or a combination thereof, that based on the one or more criteria and using at least one specially configured algorithm, identifies and/or flags portion(s) of the live data that satisfies the one or more criteria. In some embodiments, the at least one specially configured algorithm includes the one or more criteria. In one or more embodiments, to identify a portion of live data that satisfies the one or more criteria, the apparatus 200 continuously and/or periodically, in real-time or near real-time, evaluates the live data based on the one or more criteria as the live data is being received by the apparatus. In one or more embodiments, the apparatus 200 evaluates the live data to determine portion(s) of the live data that satisfy the one or more criteria. Additionally or alternatively, in one or more embodiments, the apparatus 200 identifies a portion of output data from a process simulation model that satisfies the one or more criteria. In some embodiments, to identify from a process simulation model a portion of output data that satisfies the one or more criteria, the apparatus 200 continuously and/or periodically evaluates in real-time or near real-time model-predicted data from the process simulation model based on the one or more criteria, as the model-predicted data is being outputted by the process simulation model. In one or more embodiments, the apparatus 200 evaluates the model-predicted data to determine portion(s) of the model-predicted data that satisfy the one or more criteria. In one or more embodiments, in response to identifying a portion of the data (e.g., operational and/or model-predicted data) that satisfies the one or more criteria, the apparatus flags the identified portion.

In one or more embodiments, flagging a portion of data (e.g., operational data and/or model-predicted data) that satisfies the one or more criteria comprise identifying and/or recording the timestamp associated with the portion of data that satisfies the one or more criteria. To provide context, in an example where the one or more criteria includes a steady state model, determining whether a portion of the operational data and/or model-predicted data satisfies a steady state criteria includes evaluating historic values of plant measurements (e.g., process and/or equipment variables deemed critical plant measurements) and/or evaluating mass balance closure. In an example, where the one or more criteria includes availability of a complete set of current laboratory measurements, determining whether a portion of operational data and/or model predicted data satisfies the complete set of current laboratory measurements criteria includes comparing the timestamp of the laboratory measurements with the simulation time and/or a tunable tolerance. In one or more embodiments, in response to identifying a portion of the operational data and/or model-predicted data that satisfies the one or more criteria, the apparatus 200 flags the identified portion. As described above, in one or more embodiments, flagging a portion of data that satisfies the one or more criteria includes identifying and/or recording the timestamp associated with the portion of data that satisfies the one or more criteria. In some embodiments, the apparatus 200 may flag the data for further processing (e.g., in the future). For example, in one or more embodiments, the flagged data may be extracted for external processing associated with modeling via the intelligent process modeling and simulation system 102. Such external processing may include generating, training, validating, and/or updating an intelligent model, such as intelligent model 110. In some embodiments, the apparatus 200 may cause the flagging of a portion of data that satisfies the one or more criteria, using the at least one specially configured algorithm and in a process simulation layer that run as a preprocessor to the process simulation model.

In block 406, the apparatus 200 includes intelligent model maintenance circuitry 210, process modeling simulation circuitry 212, optional control circuitry 214, communications circuitry 208, input/output circuitry 206, processor 202, and/or the like, or a combination thereof, that adopts at least one flagged portion of the live data (e.g., operational data from the plant) and/or at least one flagged portion of the model-predicted data from the process simulation model as the at least one qualifying dataset. As described above, in one or more embodiments, the at least one qualifying dataset comprise portions of data (e.g., operational data and/or model-predicted data) that is determined as qualified for generating, training, testing, and/or updating an intelligent model. Thus, integrating the intelligent model with the process simulation model.

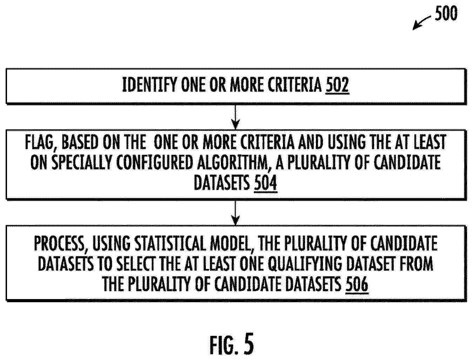

In some embodiments, the at least one qualifying dataset may be determined in accordance with the process 500 depicted in FIG. 5, which provides an example flowchart for determining, based on historical data stored in a repository (e.g., such as storage subsystem 112), at least one qualifying dataset for generating, training, and/or testing an intelligent model that is integrated with a process simulation model. The historical data may comprise operational data received from the industrial plant system and stored in the repository and/or model-predicted data outputted from a process simulation model and stored in the repository, At block 502, the apparatus 200 includes intelligent model maintenance circuitry 210, process modeling simulation circuitry 212, optional control circuitry 214, communications circuitry 208, input/output circuitry 206, processor 202, and/or the like, or a combination thereof, that identifies one or more criteria to be satisfied in order to qualify as training and/or testing dataset. In one or more embodiments, the one or more criteria is configurable, and may be identified based at least in part on the desired process simulation model and/or the desired intelligent model. As a non-limiting example, in one or more embodiments, where the process simulation model is a steady state model, the one or more criteria may include a criteria that a qualifying dataset set must comprise steady state data. As another non-limiting example, the one or more criteria may include availability of a complete set of current laboratory measurements associated with operation of the plant. As yet another non-limiting example, the one or more criteria may include that certain process values (e.g., critical process values) are within specified ranges to, for example, remove abnormal process operation such as when equipment is out of service.

At block 504, includes intelligent model maintenance circuitry 210, process modeling simulation circuitry 212, optional control circuitry 214, communications circuitry 208, input/output circuitry 206, processor 202, and/or the like, or a combination thereof, that identifies and/or flags, based on the one or more criteria and using the at least one specially configured algorithm, a plurality of candidate datasets from the historical data. A candidate dataset may comprise a portion of historical operational data and/or portions of historical model-predicted data that is determined as qualified to generate, train, test, and/or update an intelligent model. In one or more embodiments the apparatus 200 retrieves the historical operational data and the historical model-predicted data from the same repository. Such repository may comprise storage subsystem 112. In some embodiments, to identify the candidate dataset from the historical data stored in the repository, the apparatus 200 selects a time period (e.g., last 6 months, last 8 months, between June and August, etc.) and evaluates historical data associated with the selected time period. In some embodiments, the apparatus 200 may cause the flagging of a portion of data that satisfies the one or more criteria, using the at least one specially configured algorithm and in a process simulation layer that run as a preprocessor to the process simulation model.

At block 506,includes intelligent model maintenance circuitry 210, process modeling simulation circuitry 212, optional control circuitry 214, communications circuitry 208, input/output circuitry 206, processor 202, and/or the like, or a combination thereof, selects at least one dataset from the plurality of candidate datasets as the at least one qualifying dataset. The at least one qualifying dataset may comprise historical operational data that satisfies the one or more criteria, and corresponding model-predicted data that is output by a process simulation model based at least in part on the historical operational data. It would be appreciated that the at least one qualifying dataset may comprise a plurality of qualifying datasets. In one or more embodiments, the apparatus selects the at least one qualifying dataset from the plurality of candidate datasets based at least in part on the operating range of the process(es) of the plant. For example, the at least on qualifying dataset may be selected such that the complete operating range of the process(es) is covered by the at least one qualifying dataset that is selected. For example, where there are multiple operating modes, the at least one dataset may include dataset(s) that collectively cover each operation range. The datasets may include *n* (e.g., n=5, 10, 20, and/or the like) datasets for each operating mode to ensure that the datasets are balanced across the operating modes. For example, n=5 datasets may be selected for each operating mode for training an intelligent model, and n=5 datasets may be selected for each operating mode for testing/validating the intelligent model. In one or more embodiments, one or more of a variety of filtering techniques may be employed to select the at least one qualifying dataset (e.g., such as the n=5 dataset for training and testing/validation in the example described above). As such the one or more filtering techniques employed may allow a user to ensure that the selected dataset(s) covert the optimal range of key measurements (e.g., throughput, temperature, and/or the like). Additionally and/or alternatively, in one or more embodiments, to determine the at least one qualifying dataset from the plurality of candidate datasets, the apparatus processes the plurality of candidate datasets using statistical model to select the at least one qualifying dataset from the plurality of candidate datasets. In one or more embodiments, the at least one qualifying dataset is extracted for external processing associated with modeling via the process simulation system.

Returning to FIG. 3, at block 306, the apparatus 200 includes intelligent model maintenance circuitry 210, process modeling simulation circuitry 212, optional control circuitry 214, communications circuitry 208, input/output circuitry 206, processor 202, and/or the like, or a combination thereof, that trains and/or tests one or more intelligent models using the qualifying dataset. As described above, the qualifying dataset may comprise operational data (e.g., equipment and/or process variable measurements) received from the industrial plant system and/or model-predicted data outputted by a process simulation model.

At block 308, the apparatus 200 includes intelligent model maintenance circuitry 210, process modeling simulation circuitry 212, optional control circuitry 214, communications circuitry 208, input/output circuitry 206, processor 202, and/or the like, or a combination thereof, that deploys the trained intelligent model for use. In some embodiments, deploying the trained intelligent for use includes applying the trained intelligent model to a process simulation model associated with the process simulation system. In some embodiments, applying the trained intelligent model to a process simulation model may comprise causing the intelligent model to execute one or more operations to support various functionalities associated with the apparatus 200 and/or the process simulation model. In some embodiments, the apparatus 200 may cause one or more of the trained intelligent model to perform one or more pre-processing calculations, one or more post-processing calculations, and/or one or more process simulation model performance evaluations and corrections. In some embodiments, output of the one or more pre-processing calculations, output of the one or more post-processing operations, and/or output of the one or more process model performance evaluations and corrections is stored in the same repository associated with or otherwise embodied by the apparatus 200. As such, the various data associated with performing the various functionalities of the intelligent model and the process model may originate from the same data source.

In some embodiments, the output of the pre-processing operation may be provided as input to a process simulation model embodied by the apparatus 200. In some embodiments, the trained intelligent model may be configured to perform post-processing operation(s) based on live data and/or model-predicted data (e.g., predicted plant measurements) outputted by the process simulation model. In some embodiments, to perform a processing operation, the apparatus 200 retrieves plant data and/or model-predicted data stored in the repository. The apparatus then provides these data to the intelligent model as part of the input to the intelligent model. In some embodiments, the output of the intelligent model may itself comprise a model-predicted data (e.g., predicted plant measurement).

It would be appreciated that in some embodiments, the apparatus can provide live data to the intelligent model in real-time or near real-time. It would also be appreciated that in some embodiments, the apparatus can provide model-predicted data outputted from the process simulation model to the intelligent model in real-time or near real-time. For example, in some embodiments, live data from the plant and/or model-predicted data outputted by the process simulation model may be provided directly to the trained intelligent model.

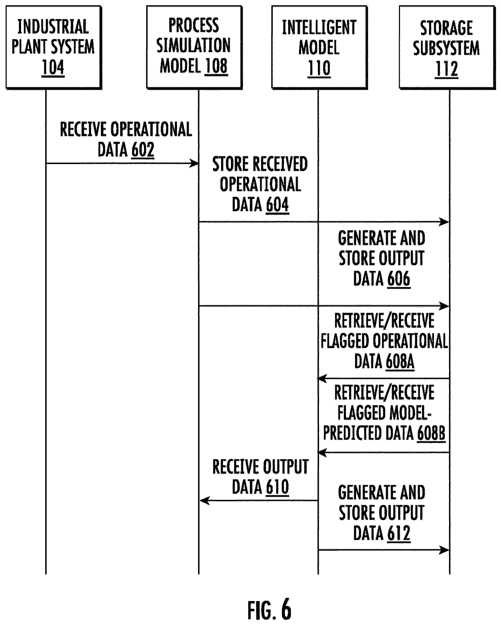

FIG. 6 provides a signal diagram of a process simulation system with integrated intelligent model(s). As depicted in FIG. 6, at least a portion of the operational data generated and transmitted by the industrial plant system 104 may be received 602 by the process simulation model 108. The operational data may also be stored 604 in a shared repository 112 (e.g., storage subsystem 112). One or more model-predicted data (e.g., output of the process simulation model) may be generated by the process simulation model 108. The generated model-predicted data may reflect predicted optimal operating points/conditions and/or otherwise may comprise data that can be used for monitoring, controlling, and/or optimizing equipment and processes associated with the industrial plant system 104. As depicted in FIG. 6, at least a portion of the operational data and a portion of the output (e.g., model-predicted data) of the process simulation model 108 may be determined to comprise a qualifying dataset 608A and 608B using at least one specially configured algorithm, The qualifying dataset(s) 608A and 608B may then be retrieved and/or received from the repository 112 based on the associated timestamp (e.g., flagged timestamp), and used to one or more of generate, train, test, and/or update an intelligent model 110. In some embodiments, the intelligent model 110 may be configured to perform one or more operations that may include pre-processing operation, post processing operation, and/or model performance evaluation and correction operation. Output of a pre-processing operation performed by the intelligent model may be input 610 to the intelligent model 110. Output of a post processing operation performed by the intelligent model 110 may comprise model-predicted data that reflects predicted optimal operating points/conditions and/or otherwise comprise data that can be used for monitoring, controlling, and/or optimizing equipment and processes associated with the industrial plant system 104.

### Conclusion

Although an example processing system has been described above, implementations of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more modules of computer program instructions, encoded on computer storage medium for execution by, or to control the operation of, information/data processing apparatus. Alternatively, or in addition, the program instructions can be encoded on an artificially-generated propagated signal, e.g., a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (e.g., multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, e.g., an FPGA (field programmable gate array) or an ASIC (application-specific integrated circuit). The apparatus can also include, in addition to hardware, code that creates an execution environment for the computer program in question, e.g., code that constitutes processor firmware, a protocol stack, a repository management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a module, component, subroutine, object, or other unit suitable for use in a computing environment. A computer program may, but need not, correspond to a file in a file system. A program can be stored in a portion of a file that holds other programs or information/data (e.g., one or more scripts stored in a markup language document), in a single file dedicated to the program in question, or in multiple coordinated files (e.g., files that store one or more modules, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, e.g., magnetic, magneto-optical disks, or optical disks. However, a computer need not have such devices. Devices suitable for storing computer program instructions and information/data include all forms of non-volatile memory, media and memory devices, including by way of example semiconductor memory devices, e.g., EPROM, EEPROM, and flash memory devices; magnetic disks, e.g., internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described herein can be implemented on a computer having a display device, e.g., a CRT (cathode ray tube) or LCD (liquid crystal display) monitor, for displaying information/data to the user and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

Embodiments of the subject matter described herein can be implemented in a computing system that includes a back-end component, e.g., as an information/data server, or that includes a middleware component, e.g., an application server, or that includes a front-end component, e.g., a client computer having a graphical user interface or a web browser through which a user can interact with an implementation of the subject matter described herein, or any combination of one or more such back-end, middleware, or front-end components. The components of the system can be interconnected by any form or medium of digital information/data communication, e.g., a communication network. Examples of communication networks include a local area network ("LAN") and a wide area network ("WAN"), an inter-network (e.g., the Internet), and peer-to-peer networks (e.g., ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some embodiments, a server transmits information/data (e.g., an HTML page) to a client device (e.g., for purposes of displaying information/data to and receiving user input from a user interacting with the client device). Information/data generated at the client device (e.g., a result of the user interaction) can be received from the client device at the server.

While this specification contains many specific implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain implementations, multitasking and parallel processing may be advantageous.

## Claims

1. A computer-implemented method integrating an intelligent model within a process simulation system, the computer-implemented method comprising:
receiving data associated with the operation of a plant;
determining, using at least one specially configured algorithm and based on the received data, at least one qualifying dataset determined qualified to train an intelligent model;
training the intelligent model using the at least one qualifying dataset; and
deploying the trained intelligent model for use.

2. The computer-implemented method of claim 1, further comprising storing the received data in a repository associated with the process simulation system.

3. The computer-implemented method of claim 1, wherein the received data comprise live data received in near real-time, and wherein determining the at least one qualifying dataset comprises:
flagging, based on one or more criteria and using the at least one specially configured algorithm, portions of the live data that satisfies the one or more criteria; and
adopting at least one of the flagged portions of the live data as the at least one qualifying dataset.

4. The computer-implemented method of claim 2, wherein determining the at least one qualifying dataset comprises:
flagging, based on one or more criteria and using the at least one specially configured algorithm, a plurality of candidate datasets from historical data; and
processing, using statistical model, the plurality of candidate datasets to select the at least one qualifying dataset from the plurality of candidate datasets.

5. The computer-implemented method of claim 1, further comprising:
extracting the at least one qualifying dataset for external processing associated with modeling via the process simulation system.

6. The computer-implemented method of claim 1, wherein the at least one qualifying dataset comprises steady state data determined to correspond to a steady state model.

7. The computer-implemented method of claim 1, wherein the at least one qualifying dataset comprises dynamic data determined to correspond to a dynamic model.

8. The computer-implemented method of claim 1, wherein the intelligent model is configured to perform one or more pre-processing operations to generate one or more parameters for a process simulation model embodied by the process simulation system.

9. The computer-implemented method of claim 1, wherein the intelligent model is configured to perform one or more post processing operations to generate one or more predictions based on data received from the plant and/or data outputted from a process simulation model.

10. An apparatus integrating an intelligent mode within a process simulation system, the apparatus comprising at least one processor and at least one non-transitory memory comprising program code stored thereon, wherein the at least one non-transitory memory and the program code are configured to, with the at least one processor, cause the apparatus to at least:
receive data associated with the operation of a plant;
determine, using at least one specially configured algorithm and based on the received data, at least one qualifying dataset determined qualified to train an intelligent model;
train the intelligent model using the at least one qualifying dataset; and
deploy the trained intelligent model for use.

11. The apparatus of claim 10, wherein the at least one non-transitory memory and the program code are configured to, with the at least one processor, further cause the apparatus to at least:
store the received data in a repository associated with the process simulation system.

12. The apparatus of claim 10, wherein the received data comprise live data received in near real-time, and wherein determining the at least one qualifying dataset comprises:
flagging, based on one or more criteria and using the at least one specially configured algorithm, portions of the live data that satisfies the one or more criteria; and
adopting at least one of the flagged portions of the live data as the at least one qualifying dataset.

13. The apparatus of claim 10, wherein determining the at least one qualifying dataset comprises:
flagging, based on one or more criteria and using the at least one specially configured algorithm, a plurality of candidate datasets; and
processing, using statistical model, the plurality of candidate datasets to select the at least one qualifying dataset from the plurality of candidate datasets.

14. The apparatus of claim 10, wherein the at least one non-transitory memory and the program code are configured to, with the at least one processor, further cause the apparatus to at least:
extract the at least one qualifying dataset for external processing associated with modeling via the process simulation system.

15. A computer program product integrating an intelligent model within a process simulation system, the computer program product comprising at least one non-transitory computer-readable storage medium having computer-readable program code portions stored therein, the computer-readable program code portions comprising an executable portion configured to:
receive data associated with the operation of a plant;
determine, using at least one specially configured algorithm and based on the received data, at least one qualifying dataset determined qualified to train an intelligent model;
train the intelligent model using the at least one qualifying dataset; and
deploy the trained intelligent model for use.
